# EUROPEAN PATENT SPECIFICATION

(11) **EP 1 342 973 B1**
(45) Date of publication and mention of the grant of the patent: **18.10.2006**
(21) Application number: 02005067.0
(22) Date of filing: 06.03.2002
(51) Int. Cl.: F28F 13/00

(54) **Device and method for absorbing and radiating heat in very small space**
Vorrichtung und Verfahren zum Absorbieren und Abstrahlen von Wärme in einem kleinen Raum
Dispositif et méthode pour absorber et irradier la chaleur dans un espace réduit

(43) Date of publication of application: 10.09.2003
(73) Proprietor: LIU, Ming-Hwa, Taiwan (TW); CHEN, Brian D.F., Taiwan (TW); CHANG, Cheng Paug, Taiwan (TW)
(72) Inventor: Liu, Ming-Hwa, Chang Hua Hsien, Taiwan (TW); Chen, Brian D.F., Taichung, Taiwan (TW); Chang, Cheng Paug, Chia Yih Hsien, Taiwan (TW)
(74) Representative: Panten, Kirsten

(56) References cited:
- US-A- 4 967 831
- US-A- 5 316 077
- US-A- 6 128 916
- US-B1- 6 272 866
- US-B1- 6 364 003

## Description

### BACKGROUND OF THE INVENTION

The present invention relates to a heat absorbing and radiating device, and more particularly to a miniature heat absorbing and radiating device suitable for use with a heat source in a very small space, such as a central processing unit (CPU) of a portable computer or a personal digital assistant (PDA).

The twenty-first century is an electronic information era. With developments in the semiconductor field, new models of various electronic products, such as desktop computers, portable computers, PDAs, mobile phones, and smart electrical appliances, have been continuously introduced into the markets. All these products are designed to have a compact volume for users to carry and use them at any time to access real-time information.

All the above-mentioned electronic products developed for the information industry include a central processing unit (CPU) that controls the entire operation of the electronic products. The CPU generates a large amount of heat and accordingly high temperature that adversely affects the operating efficiency and usable life of the products. Thus, it is always an important issue among the manufacturers to effectively cool the CPU.

The currently available solutions of cooling the CPU include the provision of a group of radiating fins and a cooling fan at outer side of the CPU, and the improvement of heat-radiating fins in their material and structure in order to more quickly radiate heat produced by the CPU. However, all these currently available solutions are passive ways with limited radiation efficiency.

Moreover, the cooling fan occupies a considerable space and does not meet the requirement of compact design.

Another available solution of cooling electrical components, such as U.S. patent No. 5,316,077, includes an assembly of a motor and a pump with an impeller inducing a flow of a cooling medium.

### SUMMARY OF THE INVENTION

It is therefore a primary object of the present invention to provide a miniature heat absorbing and radiating device having a driving unit for alternately pushing two types of fluid to actively and effectively lower the temperature of a heat source in a very small space.

Another object of the present invention is to provide a miniature heat absorbing and radiating device that has a driving unit for alternately pushing two types of fluid and does not require conventional radiating fins and cooling fans, so as to occupy only very small space.

A further object of the present invention is to provide a method for absorbing and radiating heat produced by a heat source in a very small space.

To achieve the above and other objects, the present invention provides a miniature heat absorbing and radiating device that includes a first driving unit, a heat-exchange unit, a liquid-gas confluence unit, and a liquid-gas separation chamber. The first driving unit includes a chamber in which an active magnet, a pair of fixed magnets, and a pair of passive magnets are provided. The chamber is also provided on a wall with a pair of first fluid outlets, a pair of second fluid inlets, a apir of third fluid outlets, and a pair of fourth fluid inlets. The heat-exchange unit communicates with the first driving unit and the liquid-gas confluence unit, and the liquid-gas separation chamber communicates with the liquid-gas confluence unit and one of the second fluid inlets.

### BRIEF DESCRIPTION OF THE DRAWINGS

The structure and the technical means adopted by the present invention to achieve the above and other objects can be best understood by referring to the following detailed description of the preferred embodiments and the accompanying drawings, wherein
Fig. 1 schematically shows a first driving unit adopted in a miniature heat absorbing and radiating device according to a first preferred embodiment of the present invention;
Figs. 2, 3 and 4 illustrate the operation of the first driving unit of Fig. 1;
Fig. 5 is a sectional view showing the structure of the miniature heat absorbing and radiating device according to the first preferred embodiment of the present invention including a first and second fluid storage;
Fig. 6 is a flowchart showing steps of operation of the miniature heat absorbing and radiating device of Fig. 5;
Fig. 7 is a sectional view showing the structure of the miniature heat absorbing and radiating device according to a second preferred embodiment of the present invention including the first and second fluid storage;
Fig. 8 is a flowchart showing steps of operation of the miniature heat absorbing and radiating device of Fig. 7.

### DETAILED DESCRIPTION OF THE PREFERRED EMBODIMENTS

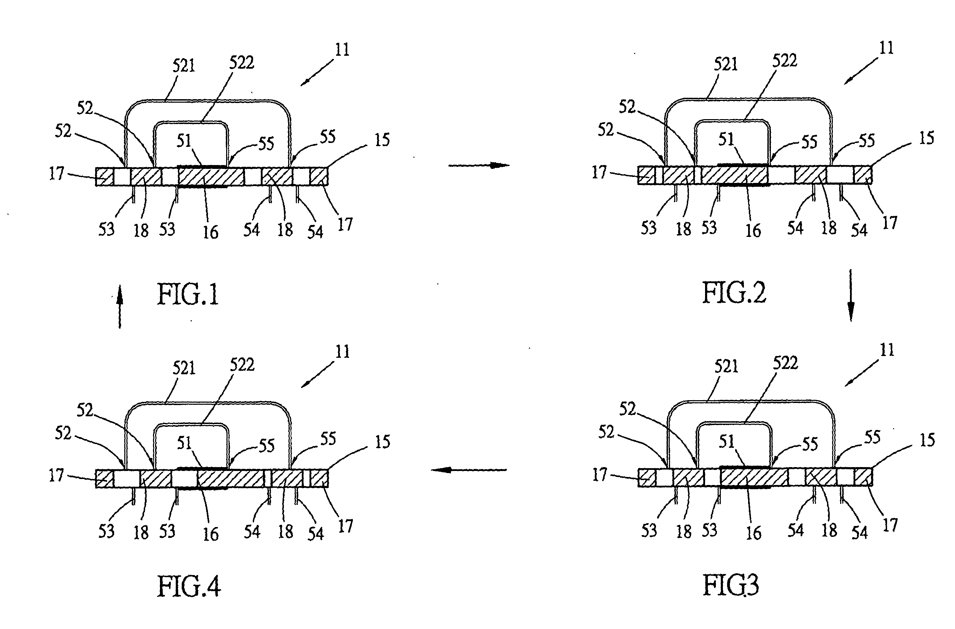

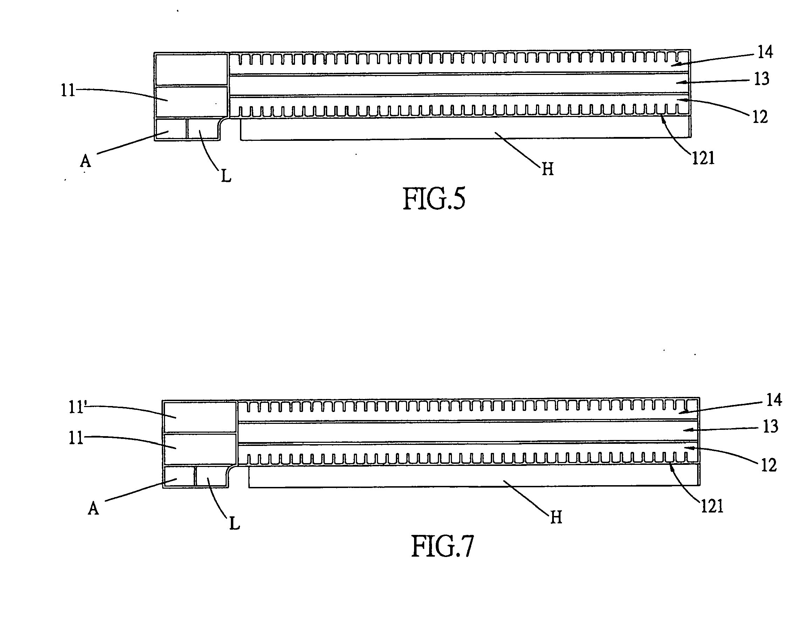

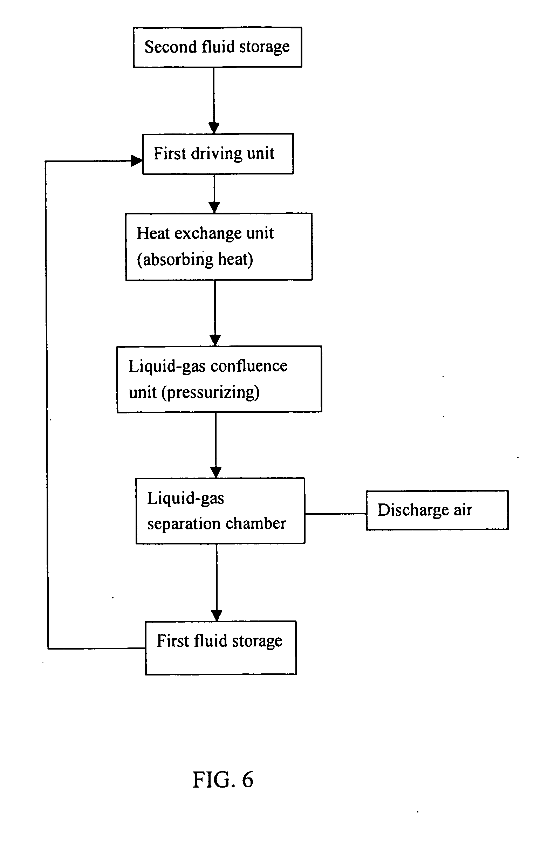

Please refer to Figs. 1 through 6. The present invention mainly relates to a miniature heat absorbing and radiating device that includes a driving unit for alternately driving two different fluids. The present invention also relates to a method for absorbing and radiating heat in a very small space by pushing alternately two different fluids included in a miniature heat absorbing and radiating device. The device according to a first preferred embodiment of the present invention, as shown in Figs. 1 to 5, mainly includes a first driving unit 11, a heat-exchange unit 12, a liquid-gas confluence unit 13, and a liquid-gas separation chamber 14.

As can be seen in Fig. 1, the first driving unit 11 includes a chamber 15 that is in the form of a tube having a predetermined shape, length and internal space, an active magnet 16, a pair of fixed magnets 17, and a pair of passive magnets 18.

The active magnet 16 has a predetermined length and an exterior shape corresponding to an interior shape of the chamber 15, and is adapted to reciprocatingly move within a middle section of the chamber 15. A coil 51 is provided around an outer wall of the chamber 15 at a portion corresponding to the active magnet 16.

The coil 51 is electrically connected to a circuit to obtain from the circuit a cyclically variable current direction for the active magnet 16 to reciprocate in the chamber 15.

The pair of fixed magnets 17 includes a left and a right magnet 17, as viewed in front of the drawings, to separately fixedly locate at and space from two ends of the active magnet 16 by a predetermined distance. Each fixed magnet 17 has a predetermined length and an exterior shape corresponding to the interior shape of the chamber 15.

The pair of passive magnets 18 includes a left and a right magnet 18, as viewed in front of the drawings, to separately locate and reciprocatingly move between the active magnet 16 and the left and the right fixed magnet 17, respectively. Each passive magnet 18 has a predetermined length and an exterior shape corresponding to the interior shape of the chamber 15.

The active magnet 16, the fixed magnets 17 and the passive magnets 18 are so arranged that ends thereof having the same polarity are located at the same side.

The chamber 15 is provided on its wall at portions between the active magnet 16 and the left fixed magnet 17 with a pair of first fluid outlets 52 and a pair of second fluid inlets 53, such that when the active magnet 16 reciprocates in the chamber 15 and causes the left passive magnet 18 to move reciprocatingly, the following conditions are observed:
(A) When the left passive magnet 18 is moved leftward to reach a maximum displacement thereof, as shown in Fig. 2, only a right one of the two first fluid outlets 52 that is located between the active magnet 16 and the left passive magnet 18 is opened, but a left one of the two first fluid outlets 52 that in open state is located between the left fixed magnet 17 and the left passive magnet 18 is closed by the left passive magnet 18 and the pair of second fluid inlets 53 are separately closed by the active magnet 16 and the left passive magnet 18;
(B) When the left passive magnet 18 is moved rightward not to reach a maximum displacement thereof, as shown in Fig. 3, the left one of the two first fluid outlets 52 that is located between the left fixed magnet 17 and the left passive magnet 18 as well as a right one of the two second fluid inlets 53 that is located between the active magnet 16 and the left passive magnet 18 are opened, while the right one of the two first fluid outlets 52 and a left one of the two second fluid inlets 53 are closed by the left passive magnet 18; and
(C) When the left passive magnet 18 is moved rightward to reach a maximum displacement thereof, as shown in Fig. 4, only the right one of the two first fluid outlets 52 that in open state is located between the active magnet 16 and the left passive magnet 18 is closed by the left passive magnet 18, but the left one of the two first fluid outlets 52 and the pair of second fluid inlets 53 are opened.
   The chamber 15 is also provided on its wall at positions between the active magnet 16 and the right fixed magnet 17 with a pair of third fluid outlets 54 and a pair of fourth fluid inlets 55, such that when the active magnet 16 reciprocates in the chamber 15 and causes the right passive magnet 18 to move reciprocatingly, the following conditions are observed:
(D) When the left passive magnet 18 is moved leftward to reach a maximum displacement thereof, as previously described in (A) and shown in Fig. 2, only a left one of the two third fluid outlets 54 that in open state is located between the active magnet 16 and the right passive magnet 18 is closed by the right passive magnet 18, but a right one of the two third fluid outlets 54 that is located between the right fixed magnet 17 and the right passive magnet 18 and the pair of fourth fluid inlets 55 are opened;
(E) When the left passive magnet 18 is moved rightward not to reach a maximum displacement thereof, as previously described in (B) and shown in Fig. 3, only the right one of the two third fluid outlets 54 that is located between the right fixed magnet 17 and the right passive magnet 18 is opened, but the left one of the two third fluid outlets 54 that in open state is located between the active magnet 16 and the right passive magnet 18 is closed by the right passive magnet 18 and the pair of fourth fluid inlets 55 are separately closed by the active magnet 16 and the right passive magnet 18; and
(F) When the left passive magnet 18 is moved rightward to reach a maximum displacement thereof, as previously described in (C) and shown in Fig. 4, only the left one of the two third fluid outlets 54 that is located between the active magnet 16 and the right passive magnet 18 is opened, but the right one of the two third fluid outlets 54 is closed by the right passive magnet 18 and the pair of fourth fluid inlets 55 are separately closed by the active magnet 16 and the right passive magnet 18.

Moreover, a first communicating tube 521 is provided to extend from the left one of the first fluid outlets 52 between the left fixed magnet 17 and the left passive magnet 18 to a right one of the fourth fluid inlets 55 between the right passive magnet 18 and the right fixed magnet 17, in order to transfer a first fluid, such as air, provided from the left one of the two second fluid inlets 53 between the left fixed magnet 17 and the left passive magnet 18 into the chamber 15.

A second communicating tube 522 is provided to extend from the right one of the first fluid outlets 52 between the active magnet 16 and the left passive magnet 18 to a left one of the fourth fluid inlets 55 between the active magnet 16 and the right passive magnet 18, in order to transfer a second fluid, such as a type of refrigerant, provided from the right one of the two second fluid inlets 53 between said active magnet 16 and the left passive magnet 18 into the chamber 15.

The heat-exchange unit 12 includes at least an expansion tube 121 having a predetermined length. The expansion tube 121 is connected at an end, that is, an inlet end, to the pair of third fluid outlets 54 to communicate with the latter. An outer side of the expansion tube 121 is pressed against a heat source H, for example, a Central Processing Unit (CPU).

The liquid-gas confluence unit 13 is a tube having a predetermined length. The liquid-gas confluence unit 13 is connected at an end, that is, an inlet end, to the other end, that is, an outlet end, of the expansion tube 121 to communicate with the latter, so as to release a pressure from a mixed gas produced after a heat exchange in the heat-exchange unit 12.

The liquid-gas separation chamber 14 has a predetermined internal space and is communicable with the other end, that is, an outlet end, of the liquid-gas confluence unit 13 and with the right one of the second fluid inlets 53 between the active magnet 16 and the left passive magnet 18. The liquid-gas separation chamber 14 is provided on its wall with an opening covered with a thin venting layer, so that hot air is discharged from the liquid-gas separation chamber 14 and said second type of fluid, for example, a refrigerant, is condensed in the liquid-gas separation chamber 14.

The method of the present invention for absorbing and radiating heat by alternately pushing two different fluids includes the following steps:
(I) Actuate the first driving unit 11 so as to alternately absorb a first and a second fluid from said pair of second fluid inlets 53 into said chamber 15 and alternately push the first and the second fluid in the chamber 15 for them to flow from the pair of first fluid outlets 52 to the pair of fourth fluid inlets 55 via the first communicating tube 521 and the second communicating tube 522;
(II) Alternately push the first and the second fluid for them to flow out of the pair of third fluid outlets 54 and into the expansion tube 121 of the heat-exchange unit 12, at where heat exchange is proceeded and a mixed gas of the first and the second fluid is produced;
(lll) Push the mixed gas into the liquid-gas confluence unit 13;
(IV) Send the mixed gas from the liquid-gas confluence unit 13 into the liquid-gas separation chamber 14;
(V) Discharge the first fluid, for example, the air, in the mixed gas from the liquid-gas separation chamber 14, and allow the second type of fluid, for example, the refrigerant, to condense into liquid phase; and
(VI) Allow the second fluid, for example, the refrigerant, to flow into the right one of the two second fluid inlet 53 between the active magnet 16 and the left passive magnet 18.

The following are advantages of the miniature heat absorbing and radiating device and the heat absorbing and radiating method of the present invention by alternately pushing two different fluids with a driving unit:
(1) With the reciprocating motion of the first driving unit 11 and the provision of the first fluid outlets 52, the second fluid inlets 53, the third fluid outlets 54, and the fourth fluid inlets 55, two types of fluid, such as refrigerant and air, are alternately pushed through the device to proceed heat exchange.
(2) Heat produced from the heat source is brought away by the air, and low-temperature air is continuously sucked into the device to proceed effective heat exchange.
(3) The use of air to replace the thermal fins and cooling fans conventionally used in a heat-radiating unit largely reduces the space needed by the heat-radiating unit and enables the same to be used in compact portable computers and mobile phones.
(4) The device of the present invention is an active heat-absorbing device operative to effectively lower temperature of a heat source.

In the above-described structure of the device according to the present invention, the expansion tube 121 further includes an uneven or a nap-finished inner wall surface to effectively hold the first and the second types of fluid to proceed a thorough heat exchange.

In the above-described structure of the device of the present invention, the liquid-gas separation chamber 14 further includes an uneven or a nap-finished inner wall surface to effectively enhance a structural strength thereof so as to bear the pressure from the mixed gas and to achieve the function of discharging the hot air and condensing the refrigerant into liquid.

In the above-described structure of the device of the present invention, the liquid-gas confluence unit 13 may include a goat-horn shaped tube having a diametrically expanded end and a diametrically reduced end. The expanded end of the liquid-gas confluence unit 13 is connected to and communicable with the outlet end of the expansion tube 121 and the reduced end of the liquid-gas confluence unit 13 is connected to and communicable with the liquid-gas separation chamber 14 to speed the flow of the mixed gas.

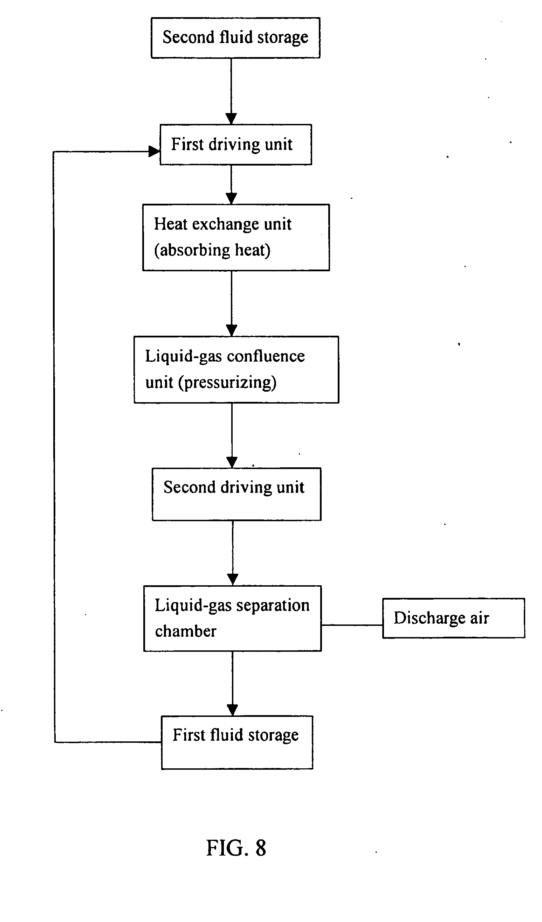

Please refer to Fig. 7 that schematically shows the structure of the miniature heat absorbing and radiating device according to a second preferred embodiment of the present invention and to Fig. 8 that is a flowchart showing steps included in the heat absorbing and radiating method according to a second preferred embodiment of the present invention. In the second preferred embodiment, the device of the present invention further includes a second driving unit 11' structurally identical to the first driving unit 11; the liquid-gas confluence unit 13 is communicably connected at the outlet end to a pair of second fluid inlets of the second driving unit 11'; and the liquid-gas separation chamber 14 is communicably connected at an inlet end to a pair of third fluid outlets of the second driving unit 11' and at an outlet end to the right one of the two second fluid inlets 53 between the active magnet 16 and the left passive magnet 18 of the first driving unit 11; such that the objects of the present invention could be more effectively achieved. In the method of the second preferred embodiment of the present invention, the following steps are included:
(I) Actuate the first and the second driving unit 11, 11', so that the first driving unit 11 alternately absorbs a first and a second fluid from said pair of second fluid inlets 53 into said chamber 15 and alternately pushes the first and the second fluid in the chamber 15 for them to flow from the pair of first fluid outlets 52 of the first driving unit 11 to the pair of fourth fluid inlets 55 of the first driving unit 11 via the first communicating tube 521 and the second communicating tube 522 of the first driving unit 11;
(II) Alternately push the first and the second fluid for them to flow out of the pair of third fluid outlets 54 of the first driving unit 11 and into the expansion tube 121 of the heat-exchange unit 12, at where heat exchange is proceeded and a mixed gas of the first and the second fluid is produced ;
(lll) Push the mixed gas into the liquid-gas confluence unit 13;
(IV) Send the mixed gas from the liquid-gas confluence unit 13 into a pair of second fluid inlets of the second driving unit 11' ;
(V) Push the mixed gas to pass a pair of third fluid outlets of the second driving unit 11' into the liquid-gas separation chamber 14; and
(VI) Discharge the first fluid, for example, the air, in the mixed gas from the liquid-gas separation chamber 14, and allow the second fluid, for example, the refrigerant, in the mixed gas to condense into liquid phase and flow into the right one of the two second fluid inlets 53 between the active magnet 16 and the left passive magnet 18 of the first driving unit 11.

In the above-described structure of the device of the second preferred embodiment of the present invention having the second driving unit 11', the liquid-gas confluence unit 13 may be communicably connected at the outlet end to only one of the second fluid inlets of the second driving unit 11', permitting low-temperature air to be guided into another one of the second fluid inlets of the second driving unit 11'. This arrangement enables the device of the present invention to more effectively lower the temperature and to provide a pressurizing effect to separate the liquid from the air. In this case, the above-described step (IV) is changed to send the mixed gas from the liquid-gas confluence unit 13 into one of a pair of second fluid inlets of the second driving unit 11'.

In the above-described structure of the device of the present invention, a first fluid storage L for storing the second type of fluid, for example, the refrigerant, may be further provided between the liquid-gas separation chamber 14 and the first driving unit 11 to obtain the same function of the present invention.

In the above-described structure of the device of the present invention, a second fluid storage A may be provided on the first communicating tube 521 to ensure accurate driving of the driving unit 11 and obtain the same function of the present invention.

## Claims

1. A miniature heat absorbing and radiating device having a driving unit (11) for pushing two different fluids alternately, said driving unit (11) including a chamber (15), an active magnet (16), a pair of fixed magnets (17), and a pair of passive magnets (18);
said chamber (15) being a tube having predetermined shape, length and internal space;
said active magnet (16) having a predetermined length and an exterior shape corresponding to an interior shape of said chamber (15), and being adapted to reciprocatingly move within a middle section of said chamber (15); a coil (51)being provided around an outer wall of said chamber (15) at a portion corresponding to said active magnet (16) to electrically connected to a circuit and thereby obtain from said circuit a cyclically variable current direction for said active magnet (16) to reciprocate in said chamber (15);
said pair of fixed magnets (17) being separately fixedly located at and spaced from two ends of said active magnet (16) by a predetermined distance, and each said fixed magnet (17) having a predetermined length and an exterior shape corresponding to the interior shape of said chamber (15);
said pair of passive magnets (18) being separately located and reciprocatingly movable between said active magnet (16) and each said fixed magnet (17), and each said passive magnet (18) having a predetermined length and an exterior shape corresponding to the interior shape of said chamber (15);
said active magnet (16), said fixed magnets (17) and said passive magnets (18) being so arranged that ends thereof having the same polarity are located at the same side;
said chamber (15) being provided on its wall at portions between said active magnet (16) and one of said fixed magnets (17) with a pair of first fluid outlets (52) and a pair of second fluid inlets (53), such that when said active magnet (16) reciprocates in said chamber (15) and causes one of said passive magnet (18) corresponding to said fixed magnet (17) to move reciprocatingly, the following conditions are observed:
(A) When said passive magnet (18) is moved leftward to reach a maximum displacement thereof, only one of said first fluid outlets (52) that is located between said active magnet (16) and said passive magnet (18) is opened, but another said first fluid outlet (52) that in open state is located between said fixed magnet (17) and said passive magnet (18) is closed by said passive magnet (18) and the pair of second fluid inlets (53) are separately closed by the active magnet (16) and said passive magnet (18);
(B) When said passive magnet (18) is moved rightward not to reach a maximum displacement thereof, another said first fluid outlet (52) that is located between said fixed magnet (17) and said passive magnet (18) as well as one of said second fluid inlets (53) that is located between said active magnet (16) and said passive magnet (18) are opened, while said first fluid outlet (52) and another said second fluid inlet (53) are closed by said passive magnet (18); and
(C) When said passive magnet (18) is moved rightward to reach a maximum displacement thereof, only said first fluid outlet (52) that in open state is located between said active magnet (16) and said passive magnet (18) is closed by said passive magnet (18), but another said first fluid outlet (52) and the pair of second fluid inlets (53) are opened;
said chamber (15) being also provided on its wall at positions between said active magnet (16) and another said fixed magnet (17) with a pair of third fluid outlets (54) and a pair of fourth fluid inlets (55), such that when said active magnet (16) reciprocates in said chamber (15) and causes another said passive magnet (18) to move reciprocatingly, the following conditions are observed:
(D) When said passive magnet (18) is moved leftward to reach a maximum displacement thereof, as previously described in (A), only one of said third fluid outlets (54) that in open state is located between said active magnet (16) and another said passive magnet (18) is closed by another said passive magnet (18), but another said third fluid outlet (54) that is located between another said fixed magnet (17) and another said passive magnet (18) and the pair of fourth fluid inlets (55) are opened;
(E) When said passive magnet (18) is moved rightward not to reach a maximum displacement thereof, as previously described in (B), only another said third fluid outlet (54) that is located between another said fixed magnet (17) and another said passive magnet (18) is opened, but said third fluid outlet (54) that in open state is located between the active magnet (16) and another said passive magnet (18) is closed by another said passive magnet (18) and the pair of fourth fluid inlets (55) are separately closed by the active magnet (16) and another said passive magnet (18); and
(F) When said passive magnet (18) is moved rightward to reach a maximum displacement thereof, as previously described in (C), only said third fluid outlet (54) that is located between said active magnet (16) and another said passive magnet (18) is opened, but another said third fluid outlet (54) is closed by another said passive magnet (18) and the pair of fourth fluid inlets (55) are separately closed by the active magnet (16) and another said magnet (18);
a first communicating tube (521) being provided to extend from another said first fluid outlet (52) between said fixed magnet (17) and said passive magnet (18) to one of the fourth fluid inlets (55) between another said passive magnet (18) and another said fixed magnet (17), in order to transfer a first fluid provided from another said second fluid inlet (53) between said fixed magnet (17) and said passive magnet (18) into said chamber (15); and
a second communicating tube (522) being provided to extend from said first fluid outlet (52) between said active magnet (16) and said passive magnet (18) to another said fourth fluid inlet (55) between said active magnet (16) and another said passive magnet (18), in order to transfer a second fluid provided from said second fluid inlet (53) between said active magnet (16) and said passive magnet (18) into said chamber (15).

2. The miniature heat absorbing and radiating device as claimed in claim 1, further comprises a heat-exchange unit (12), a liquid-gas confluence unit (13), and a liquid-gas separation chamber (14);
said heat-exchange unit (12) including at least an expansion tube (121) having a predetermined length; said expansion tube (121) being communicably connected at an end to said pair of third fluid outlets (54), and an outer side of said expansion tube (121) being pressed against a heat source;
said liquid-gas confluence unit (13) being in the form of a tube having a predetermined length and communicably connected at an end to the other end of said expansion tube (121); and
said liquid-gas separation chamber (14) having a predetermined internal space and being communicably connected to another end of said liquid-gas confluence unit (13) and to said second fluid inlet (53) between said active magnet (16) and said passive magnet (18), and said liquid-gas separation chamber (14) being provided on its wall with an opening covered with a thin venting layer.

3. The miniature heat absorbing and radiating device as claimed in claim 2, further comprises another driving unit (11') structurally identical to said driving unit (11), said another driving unit (11') being provided between said liquid-gas confluence unit (13) and said liquid-gas separation chamber (14); wherein said another end of said liquid-gas confluence unit (13) being communicably connected to a pair of second fluid inlets on said another driving unit (11'), and said liquid-gas separation chamber (14) being communicably connected to a pair of third fluid outlets on said another driving unit (11').

4. The miniature heat absorbing and radiating device as claimed in claim 2 or 3, wherein said expansion tube (121) has an uneven or a nap-finished inner wall surface.

5. The miniature heat absorbing and radiating device as claimed in one of claims 2, 3 or 4, wherein said liquid-gas separation chamber (14) has an uneven or a nap-finished inner wall surface.

6. The miniature heat absorbing and radiating device as claimed in claim 2, wherein said liquid-gas confluence unit (13) is a goat-horn shaped tube having a diametrically expanded end communicably connected to said expansion tube (121) and a diametrically reduced end communicably connected to said liquid-gas separation chamber (14).

7. The miniature heat absorbing and radiating device as claimed in claim 3, wherein said liquid-gas confluence unit (13) is a goat-horn shaped tube having a diametrically expanded end communicably connected to said expansion tube (121) and a diametrically reduced end communicably connected to said pair of second fluid inlets (53) on said second driving unit (11').

8. The miniature heat absorbing and radiating device as claimed in claim 2 or 3, further comprises a first fluid storage (L) provided between said liquid-gas separation chamber (14) and said driving unit (11).

9. The miniature heat absorbing and radiating device as claimed in claim 2 or 3, further comprises a second fluid storage (A) provided on said first communicating tube (521).

10. The miniature heat absorbing and radiating device as claimed in claim 2 or 3, wherein said first fluid comprises air and said second fluid comprises a refrigerant.

11. The miniature heat absorbing and radiating device as claimed in claim 2, further comprises another driving unit (11') structurally identical to said driving unit (11), said another driving unit (11') being provided between said liquid-gas confluence unit (13) and said liquid-gas separation chamber (14); wherein said another end of said liquid-gas confluence unit (13) is communicably connected to one of said pair of second fluid inlets on said another driving unit (11'), and said liquid-gas separation chamber (14) being communicably connected to a pair of third fluid outlets on said another driving unit (11'), so that low-temperature air is guided into said another driving unit (11') via another one of said pair of second fluid inlets of said another driving unit (11') to more effectively lower temperature and provide a pressurizing effect to separate liquid from air in said liquid-gas separation chamber (14).

12. A method for absorbing and radiating heat produced by a heat source in a very small space, comprising the steps of:
(I) Providing a driving unit for a miniature heat absorbing and radiating device for alternately pushing two different fluids as claimed in claim 2; actuating said driving unit (11) so as to alternately absorb said first and said second fluid from said pair of second fluid inlets (53) into said chamber (15) and alternately push said first and said second fluid in said chamber (15) for them to flow from said pair of first fluid outlets (52) to said pair of fourth fluid inlets (55) via said first communicating tube (521) and said second communicating tube (522);
(II) Alternately pushing said first and said second fluid for them to flow out of said pair of third fluid outlets (54) and into said expansion tube (121) of said heat-exchange unit (12), at where heat exchange is proceeded and a mixed gas of said first and said second fluid is produced;
(III) Pushing said mixed gas into said liquid-gas confluence unit (13);
(IV) Sending said mixed gas from said liquid-gas confluence unit (13) into said liquid-gas separation chamber (14);
(V) Discharging said first fluid in said mixed gas from said liquid-gas separation chamber (14), and allow said second fluid to condense into liquid phase; and
(VI) Allowing said second fluid to flow into said second fluid inlet (53) between said active magnet (16) and said passive magnet (18).

## Patentansprüche

1. Miniaturwärmeabsorptions- und Strahlungsvorrichtung, welche eine Antriebseinheit (11) zum abwechselnden Vorantreiben von zwei unterschiedlichen Fluiden hat, wobei die Antriebseinheit (11) eine Kammer (15), einen aktiven Magneten (16), ein Paar von festgelegten Magneten (17) und ein Paar von passiven Magneten (18) hat;
wobei die Kammer (15) eine Röhre ist, welche eine vorbestimmte Form, Länge und Innenraum hat;
wobei der aktive Magnet (16) eine vorbestimmte Länge und eine Außenform, welche einer Innenform der Kammer (15) entspricht, und dazu angepasst ist, sich wechselseitig innerhalb einer Mittelsektion der Kammer (15) zu bewegen; und eine Spule (51) hat, welche um eine Außenwand der Kammer (15) an einem Abschnitt bereitgestellt ist, welcher dem aktiven Magneten (16) entspricht, um elektrisch mit einer Schaltung verbunden zu sein, und daher von der Schaltung eine zyklisch variable Stromrichtung für den aktiven Magneten (16) erlangt, um sich in der Kammer (15) wechselseitig zu bewegen;
wobei sich das Paar von festgelegten Magneten (17) separat an zwei Enden des aktiven Magneten (16) befestigt und davon durch eine vorbestimmte Distanz beabstandet befindet, und wobei jeder der festgelegten Magneten (17) eine vorbestimmte Länge und Außenform, welche der Innenform von der Kammer (15) entspricht, hat;
wobei das Paar von passiven Magneten (18) sich separat und wechselseitig bewegbar zwischen dem aktiven Magneten (16) und jedem der festgelegten Magneten (17) befindet, und jeder der passiven Magneten (18) eine vorbestimmte Länge und Außenform, welche der Innenform von der Kammer (15) entspricht, hat;
wobei der aktive Magnet (16), die festgelegten Magneten (17) und die passiven Magneten (18) derart angeordnet sind, dass sich Enden derer, welche die gleiche Polarität haben, an der gleichen Seite befinden;
wobei die Kammer (15) an ihrer Wand an Abschnitten zwischen dem aktiven Magneten (16) und einem der festgelegten Magneten (17) mit einem Paar von ersten Fluid-Auslässen (52) und einem Paar von zweiten Fluid-Einlässen (53) bereitgestellt ist, so dass, wenn sich der aktive Magnet (16) in der Kammer (15) wechselseitig bewegt, und bewirkt, dass sich einer der passiven Magneten (18), welcher dem festgelegten Magneten (17) entspricht, wechselseitig bewegt, die folgenden Bedingungen beobachtet werden:
(A) Wenn der passive Magnet (18) nach links bewegt wird, um eine maximale Versetzung dadurch zu erreichen, wird lediglich einer der ersten Fluid-Auslässe (52), welcher sich zwischen dem aktiven Magneten (16) und dem passiven Magneten (18) befindet, geöffnet, jedoch wird ein weiterer aus den ersten Fluid-Auslässen (52), welcher sich in einem geöffneten Zustand zwischen dem festgelegten Magneten (17) und dem passiven Magneten (18) befindet, durch den passiven Magneten (18) geschlossen, und das Paar aus zweiten Fluid-Einlässen (53) wird separat durch den aktiven Magneten (16) und den passiven Magneten (18) geschlossen;
(B) Wenn der passive Magnet (18) nach rechts bewegt wird, um keine maximale Versetzung dadurch zu erreichen, werden ein weiterer aus den ersten Fluid-Auslässen (52), welcher sich zwischen dem festgelegten Magneten (17) und dem passiven Magneten (18) befindet, als auch einer aus den zweiten Fluid-Einlässen (53), welcher sich zwischen dem aktiven Magneten (16) und dem passiven Magneten (18) befindet, geöffnet, während der erste Fluid-Auslass (52) und ein weiterer aus den zweiten Fluid-Einlässen (53) durch den passiven Magneten (18) geschlossen werden; und
(C) Wenn der passive Magnet (18) nach rechts bewegt wird, um eine maximale Versetzung dadurch zu erreichen, wird lediglich der erste Fluid-Auslass (52), welcher sich im geöffneten Zustand zwischen dem aktiven Magneten (16) und dem passiven Magneten (18) befindet, durch den passiven Magneten (18) geschlossen, jedoch werden ein weiterer aus den ersten Fluid-Auslässen (52) und dem Paar von zweiten Fluid-Einlässen (53) geöffnet;
wobei die Kammer (15) ebenfalls an ihrer Wand an Abschnitten zwischen dem aktiven Magneten (16) und einem weiteren aus den festgelegten Magneten (17) mit einem Paar von dritten Fluid-Auslässen (54) und einem Paar von vierten Fluid-Einlässen (55) bereitgestellt ist, so dass, wenn sich der aktive Magnet (16) in der Kammer (15) wechselseitig bewegt, und bewirkt, dass sich ein weiterer aus den passiven Magneten (18) wechselseitig bewegt, die folgenden Bedingungen beobachtet werden:
(D) Wenn der passive Magnet (18) nach links bewegt wird, um eine maximale Versetzung dadurch zu erreichen, wie zuvor in (A) beschrieben, wird lediglich einer aus den dritten Fluid-Auslässen (54), welcher sich im geöffneten Zustand zwischen dem aktiven Magneten (16) und einem weiteren aus den passiven Magneten (18) befindet, durch einen weiteren aus den passiven Magneten (18) geschlossen, jedoch werden ein weiterer aus den dritten Fluid-Auslässen (54), welcher sich zwischen dem festgelegten Magneten (17) und einem weiteren aus den passiven Magneten (18) befindet, und das Paar von vierten Fluid-Einlässen (55) geöffnet;
(E) Wenn der passive Magnet (18) nach rechts bewegt wird, um keine maximale Versetzung dadurch zu erreichen, wie zuvor in (B) beschrieben, wird lediglich ein weiterer aus den dritten Fluid-Auslässen (54), welcher sich zwischen einem weiteren aus den festgelegten Magneten (17) und einem weiteren aus den passiven Magneten (18) befindet, geöffnet, jedoch werden der dritte Fluid-Auslass (54), welcher sich im geöffneten Zustand zwischen dem aktiven Magneten (16) und einem weiteren aus den passiven Magneten (18) befindet, durch einen weiteren aus den passiven Magneten (18) geschlossen, und das Paar aus vierten Fluid-Einlässen (55) wird durch die aktiven Magneten (16) und einem weiteren aus den passiven Magneten (18) geschlossen; und
(F) Wenn der passive Magnet (18) nach rechts bewegt wird, um eine maximale Versetzung dadurch zu erreichen, wie zuvor in (C) beschrieben, wird lediglich der dritte Fluid-Auslass (54), welcher sich zwischen dem aktiven Magneten (16) und einem weiteren aus den passiven Magneten (18) befindet, geöffnet, jedoch wird ein weiterer aus den dritten Fluid-Auslässen (54) durch einen weiteren aus den passiven Magneten (18) geschlossen, und das Paar aus vierten Fluid-Einlässen (55) wird separat durch den aktiven Magneten (16) und einen weiteren aus den Magneten (18) geschlossen;
wobei eine erste Verbindungsröhre (521) bereitgestellt ist, um sich von einem weiteren aus den ersten Fluid-Auslässen (52) zwischen dem festgelegten Magneten (17) und dem passiven Magneten (18) an einen aus den vierten Fluid-Einlässen (55) zwischen einem weiteren aus den passiven Magneten (18) und einem weiteren aus den festgelegten Magneten (17) zu erstrecken, um ein erstes Fluid, welches von einem weiteren aus den zweiten Fluid-Einlässen (53) zwischen den festgelegten Magneten (17) und dem passiven Magneten (18) bereitgestellt ist, in die Kammer (15) zu übertragen; und
wobei eine zweite Verbindungsröhre (522) bereitgestellt ist, um sich vom ersten Fluid-Auslass (52) zwischen dem aktiven Magneten (16) und dem passiven Magneten (18) an einen weiteren aus den vierten Fluid-Einlässen (55) zwischen dem aktiven Magneten (16) und einem weiteren aus den passiven Magneten (18) zu erstrecken, um ein zweites Fluid, welches vom zweiten Fluid-Einlass (53) zwischen dem aktiven Magneten (16) und dem passiven Magneten (18) bereitgestellt ist, in die Kammer (15) zu übertragen.

2. Miniaturwärmeabsorptions- und Strahlungsvorrichtung nach Anspruch 1, welche ferner eine Wärmetauschereinheit (12), eine Flüssiggas-Nebenflusseinheit (13) und eine Flüssiggas-Trennkammer (14) enthält,
wobei die Wärmetauschereinheit (12) zumindest eine Expansions-Röhre (121) enthält, welche eine vorbestimmte Länge hat; wobei die Expansions-Röhre (121) übertragbar an einem Ende mit dem Paar von dritten Fluid-Auslässen (54) verbunden ist, und eine Außenseite der Expansions-Röhre (121) gegen eine Wärmequelle gedrückt ist;
wobei die Flüssiggas-Nebenflusseinheit (13) in der Form einer Röhre ist, welche eine vorbestimmte Länge hat, und übertragbar an einem Ende mit dem weiteren Ende der Expansions-Röhre (121) verbunden ist; und
wobei die Flüssiggas-Trennkammer (14) einen vorbestimmten Innenraum hat und übertragbar mit einem weiteren Ende der Flüssiggas-Nebenflusseinheit (13) und dem zweiten Fluid-Einlass (53) zwischen dem aktiven Magneten (16) und dem passiven Magneten (18) verbunden ist, und wobei die Flüssiggas-Trennkammer (14) an ihrer Wand mit einer Öffnung bereitgestellt ist, welche mit einer dünnen Entlüftungsschicht bedeckt ist.

3. Miniaturwärmeabsorptions- und Strahlungsvorrichtung nach Anspruch 2, welche ferne eine weitere Antriebseinheit (11') enthält, welche strukturell mit der Antriebseinheit (11) identisch ist, wobei die weitere Antriebseinheit (11') zwischen der Flüssiggas-Nebenflusseinheit (13) und der Flüssiggas-Trennkammer (14) bereitgestellt ist, wobei das weitere Ende der Flüssiggas-Nebenflusseinheit (13) übertragbar mit einem Paar von zweiten Fluid-Einlässen an der weiteren Antriebseinheit (11') verbunden ist, und die Flüssiggas-Trennkammer (14) übertragbar mit einem Paar von dritten Fluid-Auslässen an der weiteren Antriebseinheit (11') verbunden ist.

4. Miniaturwärmeabsorptions- und Strahlungsvorrichtung nach Anspruch 2 oder 3, bei welcher die Expansions-Röhre (121) eine ungleichförmige oder mit Noppen bereitgestellte Innenwandoberfläche hat.

5. Miniaturwärmeabsorptions- und Strahlungsvorrichtung nach einem der Ansprüche 2, 3 oder 4, bei welcher die Flüssiggas-Trennkammer (14) eine ungleichförmige oder mit Noppen bereitgestellte Innenwandoberfläche hat.

6. Miniaturwärmeabsorptions- und Strahlungsvorrichtung nach Anspruch 2, bei welcher die Flüssiggas-Nebenflusseinheit (13) eine geißhornförmige Röhre ist, welche ein diametrisch erstrecktes Ende, welches übertragbar mit der Expansions-Röhre (121) verbunden ist, und ein diametrisch reduziertes Ende, welches übertragbar mit der Flüssiggas-Trennkammer (14) verbunden ist, hat.

7. Miniaturwärmeabsorptions- und Strahlungsvorrichtung nach Anspruch 3, bei welcher die Flüssiggas-Nebenflusseinheit (13) eine geißhornförmige Röhre ist, welche ein diametrisch erstrecktes Ende, welches übertragbar mit der Expansions-Röhre (121) verbunden ist, und ein diametrisch reduziertes Ende, welches übertragbar mit dem Paar von zweiten Fluid-Einlässen (53) an der zweiten Antriebseinheit (11') verbunden ist, hat.

8. Miniaturwärmeabsorptions- und Strahlungsvorrichtung nach Anspruch 2 oder 3, welche ferne einen ersten Fluid-Speicher (L) enthält, welcher zwischen der Flüssiggas-Trennkammer (14) und der Antriebseinheit (11) bereitgestellt ist.

9. Miniaturwärmeabsorptions- und Strahlungsvorrichtung nach Anspruch 2 oder 3, welche ferner ein zweites Fluid-Lager (A) enthält, welches an der ersten Verbindungs-Röhre (521) bereitgestellt ist.

10. Miniaturwärmeabsorptions- und Strahlungsvorrichtung nach Anspruch 2 oder 3, bei welcher das erste Fluid Luft enthält und das zweite Fluid ein Kühlmittel enthält.

11. Miniaturwärmeabsorptions- und Strahlungsvorrichtung nach Anspruch 2, welche ferner eine weitere Antriebseinheit (11') enthält, welche strukturell mit der Antriebseinheit (11) identisch ist, wobei die weitere Antriebseinheit (11') zwischen der Flüssiggas-Nebenflusseinheit (13) und der Flüssiggas-Trennkammer (14) bereitgestellt ist, wobei das weitere Ende der Flüssiggas-Nebenflusseinheit (13) übertragbar mit einem aus dem Paar von zweiten Fluid-Einlässen an der weiteren Antriebseinheit (11') verbunden ist, und die Flüssiggas-Trennkammer (14) übertragbar mit einem Paar von dritten Fluid-Auslässen an der weiteren Antriebseinheit (11') verbunden ist, so dass eine Niedrigtemperatur-Luft über einen weiteren aus dem Paar von zweiten Fluid-Einlässen der weiteren Antriebseinheit (11') in die weitere Antriebseinheit (11') geleitet wird, um eine Temperatur wirksamer zu verringern, und um eine Druckwirkung bereitzustellen, um in der Flüssiggas-Trennkammer (14) eine Flüssigkeit von der Luft zu trennen.

12. Verfahren zum Absorbieren und Abstrahlen von Wärme, welche durch eine Wärmequelle in einem sehr kleinen Raum erzeugt wird, welches die Schritte enthält:
(I) Bereitstellen von einer Antriebseinheit für eine Miniaturwärmeabsorptions- und Strahlungsvorrichtung zum abwechselnden Vorantreiben von zwei unterschiedlichen Fluiden nach Anspruch 2; Ansteuern der Antriebseinheit (11), um abwechselnd das erste und das zweite Fluid vom Paar aus zweiten Fluid-Einlässen (53) in die Kammer (15) zu absorbieren, und um abwechselnd das erste und das zweite Fluid in der Kammer (15) voranzutreiben, um vom Paar von ersten Fluid-Auslässen (52) an das Paar von vierten Fluid-Einlässen (55) über die erste Verbindungs-Röhre (521) und die zweite Verbindungs-Röhre (522) zu fließen;
(II) Abwechselndes Vorantreiben des ersten und des zweiten Fluids, damit sie aus dem Paar von dritten Fluid-Auslässen (54) heraus und in die Expansions-Röhre (121) der Wärmetauschereinheit (12) herein fließen, bei welcher ein Wärmetausch stattfindet und ein Mischgas aus dem ersten und dem zweiten Fluid erzeugt wird;
(III) Vorantreiben des Mischgases in die Flüssiggas-Nebenflusseinheit (13);
(IV) Übertragen des Mischgases von der Flüssiggas-Nebenflusseinheit (13) in die Flüssiggas-Trennkammer (14);
(V) Entladen des ersten Fluids im Mischgas aus der Flüssiggas-Trennkammer (14), und Zulassen, dass das zweite Fluid in eine Flüssigphase kondensiert; und
(VI) Zulassen, dass das zweite Fluid in den zweiten Fluid-Einlass (53) zwischen dem aktiven Magneten (16) und dem passiven Magneten (18) fließt.

## Revendications

1. Dispositif miniature d'absorption et de rayonnement de chaleur ayant une unité d'entraînement (11) pour pousser deux fluides différents tour à tour, ladite unité d'entraînement (11) comprenant une chambre (15), un aimant actif (16), une paire d'aimants fixes (17) et une paire d'aimants passifs (18) ;
- ladite chambre (15) étant un tube ayant une forme, une longueur et un espace interne prédéterminés ;
- ledit aimant actif (16) ayant une longueur prédéterminée et une forme extérieure correspondant à une forme intérieure de ladite chambre (15), et étant adapté pour se déplacer suivant un mouvement de va-et-vient à l'intérieur d'une section moyenne de ladite chambre (15) ; un enroulement (51) étant disposé autour d'une paroi externe de ladite chambre (15) à une partie correspondant audit aimant actif (16) pour se connecter électriquement à un circuit et obtenir de cette façon à partir dudit circuit un sens de courant variable de façon cyclique pour que ledit aimant actif (16) ait un mouvement de va-et-vient dans ladite chambre (15) ;
- ladite paire d'aimants fixes (17) étant située de façon séparée et fixe au niveau et espacée des deux extrémités dudit aimant actif (16) d'une distance prédéterminée, et chaque aimant fixe précité (17) ayant une longueur prédéterminée et une forme extérieure correspondant à la forme intérieure de ladite chambre (15) ;
- ladite paire d'aimants passifs (18) étant située séparément et étant déplaçable suivant un mouvement de va-et-vient entre ledit aimant actif (16) et chaque aimant fixe précité (17), et chaque aimant passif précité (18) ayant une longueur prédéterminée et une forme extérieure correspondant à la forme intérieure de ladite chambre (15) ;
- ledit aimant actif (16), lesdits aimants fixes (17) et lesdits aimants passifs (18) étant disposés de telle sorte que les extrémités de ceux-ci ayant la même polarité sont situées du même côté ;
- ladite chambre (15) étant dotée, sur sa paroi à des parties entre ledit aimant actif (16) et l'un desdits aimants fixes (17), d'une paire de premières sorties de fluide (52) et d'une paire de secondes entrées de fluide (53), de telle sorte que, lorsque ledit aimant actif (16) est animé d'un mouvement de va-et-vient dans ladite chambre (15) et amène l'un desdits aimants passifs (18) correspondant audit aimant fixe (17) à se déplacer suivant un mouvement de va-et-vient, les conditions suivantes sont observées :
(A) lorsque ledit aimant passif (18) est déplacé vers la gauche pour atteindre un déplacement maximal de celui-ci, seule l'une desdites premières sorties de fluide (52) qui est située entre ledit aimant actif (16) et ledit aimant passif (18) est ouverte, mais une autre première sortie de fluide précitée (52) qui à l'état ouvert est située entre ledit aimant fixe (17) et ledit aimant passif (18) est fermée par ledit aimant passif (18) et la paire de secondes entrées de fluide (53) est séparément fermée par l'aimant actif (16) et ledit aimant passif (18) ;
(B) lorsque ledit aimant passif (18) est déplacé vers la droite pour ne pas atteindre un déplacement maximal de celui-ci, une autre première sortie de fluide précitée (52) qui est située entre ledit aimant fixe (17) et ledit aimant passif (18) ainsi que l'une desdites secondes entrées de fluide (53) qui est située entre ledit aimant actif (16) et ledit aimant passif (18) sont ouvertes, tandis que ladite première sortie de fluide (52) et une autre seconde entrée de fluide précitée (53) sont fermées par ledit aimant passif (18) ; et
(C) lorsque ledit aimant passif (18) est déplacé vers la droite pour atteindre un déplacement maximal de celui-ci, seule ladite première sortie de fluide (52) qui à l'état ouvert est située entre ledit aimant actif (16) et ledit aimant passif (18) est fermée par ledit aimant passif (18), mais une autre première sortie de fluide précitée (52) et la paire de secondes entrées de fluide (53) sont ouvertes ;
ladite chambre (15) étant également dotée, sur sa paroi aux positions entre ledit aimant actif (16) et un autre aimant fixe précité (17), d'une paire de troisièmes sorties de fluide (54) et d'une paire de quatrièmes entrées de fluide (55), de telle sorte que, lorsque ledit aimant actif (16) est animé d'un mouvement de va-et-vient dans ladite chambre (15) et amène un autre aimant passif précité (18) à se déplacer suivant un mouvement de va-et-vient, les conditions suivantes sont observées :
(D) lorsque ledit aimant passif (18) est déplacé vers la gauche pour atteindre un déplacement maximal de celui-ci, comme précédemment décrit en (A), seule l'une desdites troisièmes sorties de fluide (54) qui à l'état ouvert est située entre ledit aimant actif (16) et un autre aimant passif précité (18) est fermée par un autre aimant passif précité (18), mais une autre troisième sortie de fluide précitée (54) qui est située entre un autre aimant fixe précité (17) et un autre aimant passif précité (18) et la paire de quatrièmes entrées de fluide (55) sont ouvertes ;
(E) lorsque ledit aimant passif (18) est déplacé vers la droite pour ne pas atteindre un déplacement maximal de celui-ci, comme précédemment décrit en (B), seule une autre troisième sortie de fluide précitée (54) qui est située entre un autre aimant fixe précité (17) et un autre aimant passif précité (18) est ouverte, mais ladite troisième sortie de fluide (54) qui à l'état ouvert est située entre l'aimant actif (16) et un autre aimant passif précité (18) est fermée par un autre aimant passif précité (18) et la paire de quatrièmes entrées de fluide (55) sont séparément fermées par l'aimant actif (16) et un autre aimant passif précité (18) ; et
(F) lorsque ledit aimant passif (18) est déplacé vers la droite pour atteindre un déplacement maximal de celui-ci, comme précédemment décrit en (C), seule ladite troisième sortie de fluide (54) qui est située entre ledit aimant actif (16) et un autre aimant passif précité (18) est ouverte, mais une autre troisième sortie de fluide précitée (54) est fermée par un autre aimant passif précité (18) et la paire de quatrièmes entrées de fluide (55) est séparément fermée par l'aimant actif (16) et un autre aimant précité (18) ;
un premier tube de communication (521) étant disposé pour s'étendre d'une autre première sortie de fluide précitée (52) entre ledit aimant fixe (17) et ledit aimant passif (18) à l'une des quatrièmes entrées de fluide (55) entre un autre aimant passif précité (18) et un autre aimant fixe précité (17), de façon à transférer un premier fluide provenant d'une autre second entrée de fluide précitée (53) entre ledit aimant fixe (17) et ledit aimant passif (18) dans ladite chambre (15) ; et
un second tube de communication (522) étant disposé pour s'étendre de ladite première sortie de fluide (52) entre ledit aimant actif (16) et ledit aimant passif (18) à une autre quatrième entrée de fluide précitée (55) entre ledit aimant actif (16) et un autre aimant passif précité (18), de façon à transférer un second fluide provenant de ladite seconde entrée de fluide (53) entre ledit aimant actif (16) et ledit aimant passif (18) dans ladite chambre (15).

2. Dispositif miniature d'absorption et de rayonnement de chaleur, selon la revendication 1, comprenant en outre une unité d'échange de chaleur (12), une unité de confluence liquide-gaz (13) et une chambre de séparation liquide-gaz (14) ;
- ladite unité d'échange de chaleur (12) comprenant au moins un tube d'expansion (121) ayant une longueur prédéterminée ; ledit tube d'expansion (121) étant connecté de façon communicante à une extrémité à ladite paire de troisièmes sorties de fluide (54), et un côté externe dudit tube d'expansion (121) étant pressé contre une source de chaleur ;
- ladite unité de confluence liquide-gaz (13) étant de la forme d'un tube ayant une longueur prédéterminée et connectée de façon communicante à une extrémité à l'autre extrémité dudit tube d'expansion (121) ; et
- ladite chambre de séparation liquide-gaz (14) ayant un espace interne prédéterminé et étant connectée de façon communicante à une autre extrémité de ladite unité de confluence liquide-gaz (13) et à ladite seconde entrée de fluide (53) entre ledit aimant actif (16) et ledit aimant passif (18), et ladite chambre de séparation liquide-gaz (14) étant dotée sur sa paroi d'une ouverture recouverte d'une fine couche d'aération.

3. Dispositif miniature d'absorption et de rayonnement de chaleur selon la revendication 2, comprenant en outre une autre unité d'entraînement (11') structuralement identique à ladite unité d'entraînement (11), ladite autre unité d'entraînement (11') étant disposée entre ladite unité de confluence liquide-gaz (13) et ladite chambre de séparation liquide-gaz (14) ; dans lequel ladite autre extrémité de ladite unité de confluence liquide-gaz (13) étant connectée de façon communicante à une paire de secondes entrées de fluide sur ladite autre unité d'entraînement (11'), et ladite chambre de séparation liquide-gaz (14) étant connectée de façon communicante à une paire de troisièmes sorties de fluide sur ladite autre unité d'entraînement (11').

4. Dispositif miniature d'absorption et de rayonnement de chaleur, selon l'une des revendications 2 ou 3, dans lequel ledit tube d'expansion (121) a une surface de paroi interne irrégulière ou à fini grossier.

5. Dispositif miniature d'absorption et de rayonnement de chaleur, selon l'une des revendications 2, 3 ou 4, dans lequel ladite chambre de séparation liquide-gaz (14) a une surface de paroi interne irrégulière ou à fini grossier.

6. Dispositif miniature d'absorption et de rayonnement de chaleur, selon la revendication 2, dans lequel ladite unité de confluence liquide-gaz (13) est un tube en forme de corne de chèvre, ayant une extrémité diamétralement élargie, connectée de façon communicante audit tube d'expansion (121), et une extrémité diamétralement réduite, connectée de façon communicante à ladite chambre de séparation liquide-gaz (14).

7. Dispositif miniature d'absorption et de rayonnement de chaleur, selon la revendication 3, dans lequel ladite unité de confluence liquide-gaz (13) est un tube en forme de corne de chèvre ayant une extrémité diamétralement élargie, connectée de façon communicante audit tube d'expansion (121), et une extrémité diamétralement réduite, connectée de façon communicante à ladite paire de secondes entrées de fluide (53) sur ladite seconde unité d'entraînement (11').

8. Dispositif miniature d'absorption et de rayonnement de chaleur, selon l'une des revendications 2 ou 3, comprenant en outre un premier stockage de fluide (L) disposé entre ladite chambre de séparation liquide-gaz (14) et ladite unité d'entraînement (11).

9. Dispositif miniature d'absorption et de rayonnement de chaleur, selon l'une des revendications 2 ou 3, comprenant en outre un second stockage de fluide (A) disposé sur ledit premier tube de communication (521).

10. Dispositif miniature d'absorption et de rayonnement de chaleur, selon l'une des revendications 2 ou 3, dans lequel ledit premier fluide comprend de l'air et ledit second fluide comprend un réfrigérant.

11. Dispositif miniature d'absorption et de rayonnement de chaleur, selon la revendication 2, comprenant en outre une autre unité d'entraînement (11') structuralement identique à ladite unité d'entraînement (11), ladite autre unité d'entraînement (11') étant disposée entre ladite unité de confluence liquide-gaz (13) et ladite chambre de séparation liquide-gaz (14) ; dans lequel ladite autre extrémité de ladite unité de confluence liquide-gaz (13) est connectée de façon communicante à l'une de ladite paire de secondes entrées de fluide sur ladite autre unité d'entraînement (11'), et ladite chambre de séparation liquide-gaz (14) étant connectée de façon communicante à une paire de troisièmes sorties de fluide sur ladite autre unité d'entraînement (11'), de telle sorte que de l'air à basse température est guidé dans ladite autre unité d'entraînement (11') par l'intermédiaire d'une autre de ladite paire de secondes entrées de fluide de ladite autre unité d'entraînement (11') pour abaisser de façon plus efficace la température et fournir un effet pressurisant pour séparer le liquide de l'air dans ladite chambre de séparation liquide-gaz (14).

12. Procédé pour absorber et rayonner la chaleur produite par une source de chaleur dans un très petit espace, comprenant les étapes consistant à :
(I) prendre une unité d'entraînement pour un dispositif miniature d'absorption et de rayonnement de chaleur pour pousser tour à tour deux fluides différents, tel que défini à la revendication 2 ; actionner ladite unité d'entraînement (11) de façon à absorber tour à tour ledit premier et ledit second fluide à partir de ladite paire de secondes entrées de fluide (53) dans ladite chambre (15) et à pousser tour à tour ledit premier et ledit second fluide dans ladite chambre (15) pour qu'ils s'écoulent de ladite paire de premières sorties de fluide (52) à ladite paire de quatrièmes entrées de fluide (55) par l'intermédiaire dudit premier tube de communication (521) et dudit second tube de communication (522) ;
(II) pousser tour à tour ledit premier et ledit second fluide pour qu'ils s'écoulent hors de ladite paire de troisièmes sorties de fluide (54) et dans ledit tube d'expansion (121) de ladite unité d'échange de chaleur (12), là où l'échange de chaleur est réalisé et un gaz mélangé dudit premier et dudit second fluide est produit ;
(III) pousser ledit gaz mélangé dans ladite unité de confluence liquide-gaz (13) ;
(IV) envoyer ledit gaz mélangé de ladite unité de confluence liquide-gaz (13) dans ladite chambre de séparation liquide-gaz (14) ;
(V) décharger ledit premier fluide dans ledit gaz mélangé à partir de ladite chambre de séparation liquide-gaz (14), et permettre audit second fluide de se condenser en phase liquide ; et
(VI) permettre audit second fluide de s'écouler dans ladite seconde entrée de fluide (53) entre ledit aimant actif (16) et ledit aimant passif (18).
